# EUROPEAN PATENT APPLICATION

(11) **EP 4 503 125 A1**
(43) Date of publication of application: **05.02.2025**
(21) Application number: 23197663.0
(22) Date of filing: 15.09.2023
(51) Int. Cl.: H01L 25/075, H01L 33/48, F21Y 105/12

(54) **LED MODULE**

(30) Priority: 04.08.2023 CN 202322104691 U
(71) Applicant: Li, Wenjie, Guangzhou Guangdong (CN)
(72) Inventor: Li, Wenjie, Guangzhou (CN)
(74) Representative: Zaboliene, Reda

(57) **Abstract**

A Light Emitting Diode (LED) module includes a substrate, a light-concentrating LED chip, and a plurality of flood LED chips. The light-concentrating LED chip is arranged in a center of the substrate; a geometric center of each flood LED chip is equidistant from a geometric center of the light-concentrating LED chip, and a distance between the geometric center of the flood LED and the geometric center of the light-concentrating LED chip is greater than a maximum inscribed circle diameter of a counter shape of the flood LED chip; In the application, the light-concentrating LED chip and the flood LED chips are arranged to achieve both the light-concentrating and flood effects, and the layout of the arranged LED chips is reasonable, which is conducive to the overall heat dissipation and has a long service life.

## Description

### CROSS-REFERENCE TO RELATED APPLICATIONS

This application claims priority to Chinese Patent Application No. 202322104691.7, filed on August 4, 2023, the content of which is incorporated herein by reference in its entirety.

### TECHNICAL FIELD

The application relates to the technical field of lighting facilities, in particular to a Light Emitting Diode (LED) Module.

### BACKGROUND

An LED chip has high brightness and low energy consumption, and is often used in a lighting facility. In order to achieve the comprehensive requirements of the lighting facility for the range, brightness and illumination range, the lighting facility in the related art often needs to configure an LED module composed of a plurality of LED chips as a light source, and achieves a specific illumination effect by using a plurality of LED chip combinations.

For the LED module in the related art, in order to ensure sufficient luminous flux, a distance between the LED chips in the LED module is usually arranged to be small, and the overall layout of the LED chips is relatively dense, which is not conducive to the heat dissipation of the LED module, thereby affecting the service life of the LED module.

### SUMMARY

The application provides an LED module to solve the problem that the layout of LED chips in the LED module in the related art is relatively dense, which is not conducive to the heat dissipation of the LED module, thereby affecting the service life of the LED module.

In order to achieve the above objective, the application adopts the following technical solution.

An LED module includes a substrate, a light-concentrating LED chip, and a plurality of flood LED chips, the light-concentrating LED chip providing a concentrated light and the flood LED chips providing a flood light.

The light-concentrating LED chip is arranged in the center of the substrate.

A geometric center of each flood LED chip is equidistant from a geometric center of the light-concentrating LED chip, and a distance between the geometric center of the flood LED and the geometric center of the light-concentrating LED chip is greater than the maximum inscribed circle diameter of the counter shape of the flood LED chip.

The distance between the geometric center of the flood LED and the geometric center of the light-concentrating LED chip is greater than the sum of the maximum inscribed circle radiuses of the flood LED and the light-concentrating LED chip.

A distance between the geometric centers of the adjacent flood LEDs is greater than the maximum inscribed circle diameter of the counter shape of the flood LED chip.

Further, eight flood LED chips are provided.

Further, the eight flood LED chips are divided into four groups with two adjacent flood LED chips forming one group, intra-group chip connections of two groups of flood LED chips in opposite directions are parallel to each other, and intra-group chip connections of two adjacent groups of flood LED chips are perpendicular to each other.

Further, surfaces of the light-concentrating LED chip and the flood LED chips are also covered with fluorescent powder through full spray.

Further, the light-concentrating LED chip and the flood LED chips are connected in the form of a common cathode.

Further, the light-concentrating LED chip is packaged with a vertical structure.

Further, the flood LED chips are packaged with an inverted structure.

The application has the following beneficial effects.

The light-concentrating LED chip and the flood LED chips are arranged to achieve both the light-concentrating and flood effects, and the layout of the arranged LED chips is reasonable, which is conducive to the overall heat dissipation and has a long service life.

### BRIEF DESCRIPTION OF THE DRAWINGS

Fig. 1 is a schematic layout diagram of an LED chip of an LED module.
Fig. 2 is a schematic wiring diagram of an LED chip of an LED module.

### DETAILED DESCRIPTION OF THE EMBODIMENTS

In order to make the purposes, technical solutions and advantages of the embodiments of the application clearer, the technical solutions of the application will be further clearly and completely described below in combination with the embodiments of the application. It is to be noted that the described embodiments are a part of the embodiments of the application, and not all of them. All other embodiments obtained by those of ordinary skill in the art based on the embodiments of the application without creative efforts are within the scope of protection of the application.

It is to be noted that if directional indications (such as upper, down, left, right, front, rear, top, bottom, inside, outside, vertical, horizontal, longitudinal, counterclockwise, clockwise, circumferential, radial, axial, etc.) are involved in the embodiments of the application, the directional indications are only used to explain the relative positional relationships, movement, etc. between various parts under a specific attitude (as shown in the accompanying drawings). If the specific attitude changes, the directional indications are changed accordingly.

The term "and/or" in the embodiments of the application is only an association relationship describing associated objects, and represents that three relationships may exist. For example, A and/or B may represent three conditions: i.e., existence of only A, existence of both A and B, and existence of only B.

The terms "first" and "second" are used for descriptive purposes only, and cannot be understood as indicating or implying relative importance or implicitly indicating the number of indicated technical features. Therefore, the features defined with "first" and "second" may explicitly or implicitly include at least one of the features. In the description of the application, terms "include" and "have" and any variations thereof are intended to cover non-exclusive inclusions. For example, a system, product, or device including a series of parts or units is not limited to the parts or units which have been listed but optionally further includes parts or units which are not listed or optionally further includes other parts or units intrinsic to the product, or the device. In the description of the application, "plurality" means at least two, such as two, three, etc. unless otherwise specified and defined.

"Embodiment" mentioned herein means that a specific feature, structure, or characteristic described in combination with an embodiment may be included in at least one embodiment of the application. The phrase appearing anywhere in the specification does not always refer to the same embodiment or an independent or alternative embodiment mutually exclusive of another embodiment. It is explicitly and implicitly understood by those skilled in the art that the embodiments described herein may be combined with other embodiments.

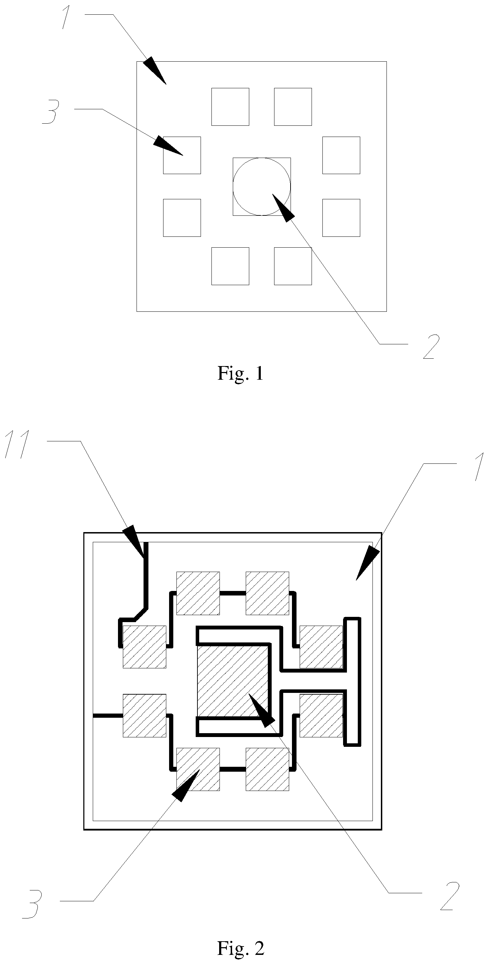

The application provides an LED module, as shown in Fig. 1, the LED module of the application is provided with a plurality of LED chips on a substrate 1. In the existing LED chips, a special LED chip with high optical density packaged with a vertical structure has a long range and may be configured to provide a concentrated light (distant light) in a searchlight device. However, luminous flux provided by the specific LED chip is small, so that in the LED module of the application, and the special LED chip is placed in the middle of the substrate 1 as a light-concentrating LED chip 2 in the application, around which a plurality of flood LED chips 3 configured to provide a flood light are arranged.

In preferred embodiments, in order to achieve better heat dissipation and combined lighting effects of the LED module, and to reserve a track distance for each LED chip, eight square flood LEDs 3 with the same specifications are arranged in the embodiment, and the eight flood LEDs 3 are packaged with an inverted structure. Distances between geometric centers of the eight flood LEDs 3 and a geometric center of the light-concentrating LED chip 2 are the same, and are greater than the maximum inscribed circle diameter of the counter shape of the flood LED 3 (that is, the geometric centers of the eight flood LEDs 3 are located at a circle centered on the geometric center of the light-concentrating LED chip 2). The distance between the geometric center of the flood LED 3 and the geometric center of the light-concentrating LED chip 2 is greater than the sum of the maximum inscribed circle radiuses of the flood LED 3 and the light-concentrating LED chip 2. A distance between the geometric centers of the adjacent flood LEDs 3 is greater than the maximum inscribed circle diameter of the counter shape of the flood LED chip 3. In addition, the eight flood LED chips 3 are also divided into four groups with two adjacent flood LED chips forming one group, intra-group chip connections of two groups of flood LED chips in opposite directions are parallel to each other, and intra-group chip connections of two adjacent groups of flood LED chips are perpendicular to each other.

As shown in Fig. 2, in the application, in order to control the heat dissipation on the basis of ensuring a uniform lighting effect, cathodes of the light-concentrating LED chip 2 and the flood LED chips 3 are connected to a negative line 11, that is, the light-concentrating LED chip 2 and the flood LED chips 3 are connected in the form of a common cathode.

As a preferred embodiment of improving the overall lighting effect, surfaces of the light-concentrating LED chip 2 and the flood LED chips 3 are also covered with fluorescent powder through full spray.

In the application, the light-concentrating LED chip and the flood LED chips are arranged to achieve both the light-concentrating and floodlighting effects, and the layout of the arranged LED chips is reasonable, which is conducive to the overall heat dissipation and has a long service life.

The above embodiments are merely illustrative of implementation modes of the application with specific and detailed description, and are not to be construed as limiting the patent scope of the application. It is to be noted that a number of variations and modifications may be made by those of ordinary skill in the art without departing from the conception of the application, and all fall within the scope of protection of the application. Therefore, the scope of protection of the application should be determined by the appended claims.

## Claims

1. A Light Emitting Diode (LED) module, comprising a substrate, a light-concentrating LED chip, and a plurality of flood LED chips, wherein
the light-concentrating LED chip provides a concentrated light and the flood LED chips provide a flood light;
the light-concentrating LED chip is arranged in a center of the substrate;
a geometric center of each flood LED chip is equidistant from a geometric center of the light-concentrating LED chip, and a distance between the geometric center of the flood LED and the geometric center of the light-concentrating LED chip is greater than a maximum inscribed circle diameter of a counter shape of the flood LED chip;
the distance between the geometric center of the flood LED and the geometric center of the light-concentrating LED chip is greater than a sum of a maximum inscribed circle radiuses of the flood LED and the light-concentrating LED chip; and
a distance between the geometric centers of the adjacent flood LEDs is greater than the maximum inscribed circle diameter of the counter shape of the flood LED chip.

2. The LED module according to claim 1, wherein eight flood LED chips are provided.

3. The LED module according to claim 2, wherein the eight flood LED chips are divided into four groups with two adjacent flood LED chips forming one group, intra-group chip connections of two groups of flood LED chips in opposite directions are parallel to each other, and intra-group chip connections of two adjacent groups of flood LED chips are perpendicular to each other.

4. The LED module according to claim 1, wherein surfaces of the light-concentrating LED chip and the flood LED chips are also covered with fluorescent powder through full spray.

5. The LED module according to claim 1, wherein the light-concentrating LED chip and the flood LED chips are connected in a form of a common cathode.

6. The LED module according to claims 1, wherein the light-concentrating LED chip is packaged with a vertical structure.

7. The LED module according to claim 6, wherein the flood LED chips are packaged with an inverted structure.
